(19) Europäisches Patentamt
European Patent Office
Office européen des brevets

(11) **EP 2 071 624 A1**

(12) **DEMANDE DE BREVET EUROPEEN**

(43) Date de publication:
**17.06.2009 Bulletin 2009/25**

(51) Int Cl.:
***H01L 23/544*** (2006.01)

(21) Numéro de dépôt: **08169227.9**

(22) Date de dépôt: **17.11.2008**

(84) Etats contractants désignés:
**AT BE BG CH CY CZ DE DK EE ES FI FR GB GR HR HU IE IS IT LI LT LU LV MC MT NL NO PL PT RO SE SI SK TR**
Etats d'extension désignés:
**AL BA MK RS**

(30) Priorité: **21.11.2007 FR 0759196**

(71) Demandeur: **Commissariat à l'Energie Atomique 75015 Paris (FR)**

(72) Inventeur: **Toffoli, Alain
38450, Le Gua (FR)**

(74) Mandataire: **Ilgart, Jean-Christophe et al
BREVALEX
3, rue du Docteur Lancereaux
75008 Paris (FR)**

(54) **Dispositif pour mesures d'épaisseur et de résistivité carrée de lignes d'interconnexions**

(57) La présente description concerne un dispositif microélectronique comprenant : un ou plusieurs niveaux métalliques d'interconnexions superposés, et au moins une structure de test comportant :
- moins une zone métallique (110) formée dans au moins une zone isolante (100), la zone métallique comportant :
• au moins une première portion métallique (112) par laquelle un courant est destiné à être injecté et au moins une deuxième portion métallique (114) par laquelle ledit courant est destiné à être extrait,
• au moins une troisième portion métallique destinée à servir de premier point de mesure d'une tension, et au moins une quatrième portion métallique destinée à servir de deuxième point de mesure de ladite tension,
• une pluralité d'ilots isolants (140) incorporés dans ladite zone métallique,

ladite structure comportant en outre :

- une pluralité d'ilots métalliques (130) incorporés dans la zone isolante et répartis autour de ladite zone métallique (110).

FIG.2

## Description

## DOMAINE TECHNIQUE

L'invention concerne le domaine de la microélectronique et en particulier celui des structures de test dans les circuits intégrés, prévues pour des mesures de résistance, et/ou de résistance carrée, et/ou d'épaisseur de lignes conductrices.

Elle prévoit la mise en oeuvre d'une structure de test comportant une large zone métallique par laquelle un courant est destiné à circuler et aux bornes de laquelle une tension est destinée à être mesurée, et de moyens pour empêcher les phénomènes communément appelés de « dishing » et « d'érosion » sur et autour de cette zone métallique, et qui conduisent à la formation de surfaces non planes.

## ÉTAT DE LA TECHNIQUE ANTÉRIEURE

Les dispositifs microélectroniques comprennent généralement des interconnexions servant à relier des composants et/ou des circuits entre eux, sous forme de zones métalliques horizontales ou lignes métalliques réparties sur un ou plusieurs niveaux, et qui s'étendent dans une direction parallèle au plan principal d'un substrat sur lequel lesdits composants reposent. Des éléments métalliques reliant une ou plusieurs zones métalliques entre elles sont également prévus afin de former des contacts entre les différents niveaux de lignes métalliques.

Les lignes métalliques peuvent être par exemple à base d'aluminium ou de cuivre, et sont formées lors d'étapes de procédé communément appelées de "Backend".

Après la réalisation des lignes métalliques, il peut s'avérer nécessaire de mesurer les dimensions et/ou les paramètres physiques de ces dernières. On souhaite généralement mesurer l'épaisseur et la largeur des lignes, ainsi que certains paramètres physiques tels que la résistance Rc carrée :

$$Rc = \rho/e$$

avec Rc, la résistance carrée d'une ligne, p la résistivité du matériau métallique de la ligne, et e, l'épaisseur de la ligne.

Les lignes métalliques, notamment dans les technologies sub-microniques, c'est-à-dire pour lesquelles on réalise des motifs de dimensions critiques inférieures à 1 $\mu$m, peuvent être réalisées à l'aide d'un procédé de type appelé « damascène ». Pour former un niveau métallique à l'aide d'un tel procédé, on remplit une ou plusieurs tranchées réalisées au préalable dans une couche isolante à l'aide d'un métal tel que du cuivre, puis on effectue un polissage mécano-chimique pour éliminer une épaisseur de matériau métallique superflue afin d'obtenir des lignes métalliques ayant une surface plane et homogène, de manière à ensuite pouvoir empiler un niveau supérieur.

Un inconvénient de cette étape de polissage réside dans l'apparition de phénomènes communément appelés de « dishing » et « d'érosion », qui sont dus à un retrait inhomogène de matériau métallique à base duquel les lignes sont formées, ou de matériau isolant suivant le rapport de surface occupée entre ces matériaux.

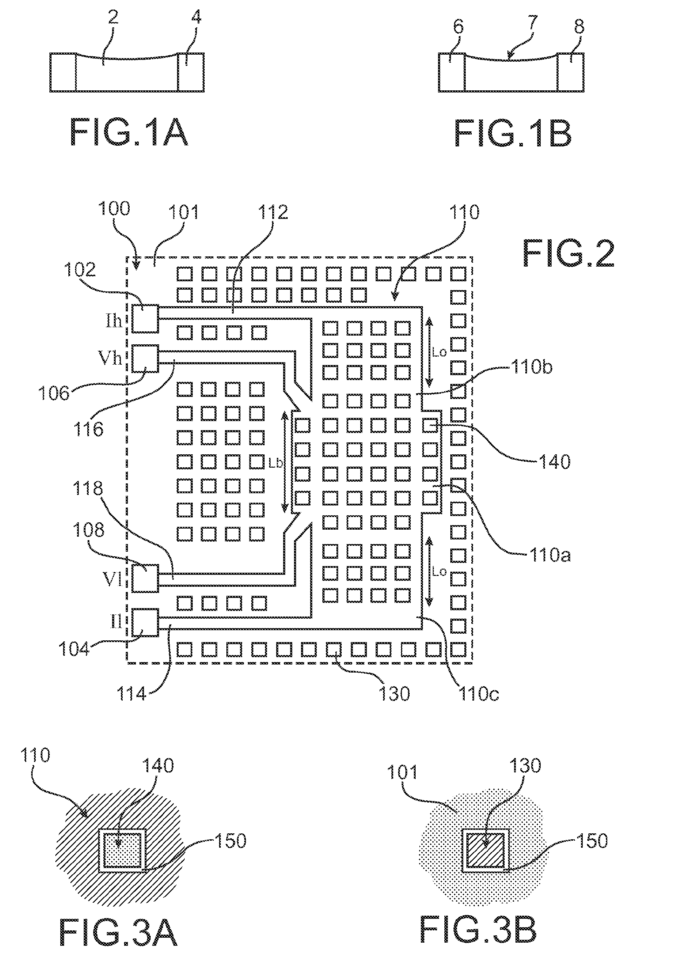

Sur la figure 1A, une ligne métallique 2 formée dans une couche de matériau isolant 4 et creusée par phénomène de « dishing » est représentée. Ce phénomène est induit par le fait que la surface occupée par cette ligne métallique 2 est beaucoup plus importante que celle du matériau isolant 4 entourant cette ligne.

Sur la figure 1B, des lignes métalliques 6 et 8 séparées par une zone 7 de matériau isolant creusée par phénomène « d'érosion » sont représentées. Ce phénomène provient du fait que la surface occupée par la zone isolante 7 est beaucoup plus importante que celles des lignes métalliques 6 et 8 entourant cette zone.

Les mesures de résistance carrée, pour des dispositifs qui n'ont pas été mis en oeuvre à l'aide de polissage mécano-chimique, peut être mesurée à l'aide d'une structure ayant un motif de Vanderpauw tel que cela est décrit dans le document « A method for measuring the resistivity and Hall Coefficient on lamellae of arbitrary shape », Philips technical review 20 : 220-224, 1954. et qui permet d'extraire la résistivité et l'épaisseur.

Dans le cas des technologies sub-microniques, une telle structure ne peut être utilisée. En effet, pour obtenir une mesure précise, la dimension critique de la structure de mesure est de préférence supérieure à plusieurs micromètres, par exemple 5 $\mu$m, ce qui implique des effets de « dishing » lors de sa réalisation. De tels effets de « dishing », se traduisent lors d'une mesure par une valeur de résistance carré mesurée sur la structure de test supérieure à celle des lignes métalliques d'interconnexion réelles, qui du fait de leur dimension critique plus faible, ne subissent pas l'effet de « dishing ».

Le document EP 0 825 644 A présente une réalisation d'un dispositif microélectronique comprenant une structure dite « dummy » comportant au moins une zone conductrice et une pluralité d'ilots conducteurs répartis autour de ladite zone conductrice, prévue afin d'équilibrer un taux de polissage.

Il se pose le problème de trouver une solution technique à la fois à des problèmes de « dishing » et d'érosion.

Dans le document «Accurate method for determination of interconnect cross section», X. Federspiel and Al., une autre méthode de mesure de l'épaisseur d'une ligne métallique d'interconnexion est proposée. Elle consiste à mesurer les dimensions d'un échantillon à l'aide d'un microscope électronique à balayage (SEM), et calculer les paramètres d'autres dispositifs, en utilisant cet échantillon comme référence. Cette méthode a pour inconvénient de nécessiter l'utilisation d'un équipement coûteux, et d'être incompatible avec des exigences de rapidité inhérentes aux procédés de fabrication industriels.

Il se pose également le problème de trouver un nouveau procédé de mesure d'épaisseur et/ou de résistance carré de lignes métalliques, qui ne comprend pas les inconvénients mentionnés ci-dessus.

**EXPOSÉ DE L'INVENTION**

L'invention concerne tout d'abord un dispositif microélectronique doté d'un ou plusieurs niveaux métalliques d'interconnexions superposés, et au moins une structure de test comprenant :

- au moins une zone métallique formée dans au moins une zone isolante, la zone métallique comportant :

  • au moins une première portion métallique par laquelle un courant est destiné à être injecté et au moins une deuxième portion métallique par laquelle ledit courant est destiné à être extrait,
  • au moins une troisième portion métallique destinée à servir de premier point de mesure d'une tension, et au moins une quatrième portion métallique destinée à servir de deuxième point de mesure de ladite tension, une pluralité d'ilots isolants étant incorporés dans ladite zone métallique, ladite structure comportant en outre :

- une pluralité d'ilots métalliques incorporés dans la zone isolante et répartis autour de ladite zone métallique.

L'invention permet également de remédier à la fois aux effets de « dishing » et « d'érosion » dus au polissage mécano-chimique, pour que l'épaisseur et la résistance carrée mesurées sur cette structure soient les mêmes que celles des lignes d'interconnexions dans les circuits.

Le nombre et la taille des ilots métalliques peuvent être prévus au moins en fonction de la surface totale occupée par la zone métallique et du nombre et de la taille des ilots isolants de matériau diélectrique.

Le nombre et la taille des ilots métalliques peuvent être prévus au moins en fonction de la surface et de la géométrie de la zone de matériau diélectrique, afin d'équilibrer les surfaces de matériau métallique et de matériau diélectrique. Le nombre et la taille des ilots de matériau diélectrique peuvent être également prévus au moins en fonction de la surface et de la géométrie occupée par la zone de matériau métallique, afin d'équilibrer les surfaces de matériau métallique et de matériau diélectrique.

Les ilots métalliques et isolant sont prévus de manière à équilibrer les surfaces des matériaux métallique et isolants.

Les ilots métalliques et isolants permettent d'équilibrer la surface de matériau métallique et de matériau diélectrique à l'intérieur de la zone isolante.

Le nombre et la taille des ilots métalliques et des ilots isolants peuvent être prévus de sorte que, à l'intérieur de la zone isolante, la surface de matériau diélectrique et de matériau métallique sont égales ou diffèrent de moins de 10 %.

La zone isolante peut avoir une surface comprise entre 1,5 fois et 2,5 fois la surface de la zone métallique.

La zone isolante peut entourer la surface métallique et avoir une surface environ deux fois supérieure à celle de la zone métallique.

Une couche barrière de diffusion peut être prévue autour des ilots métalliques et/ou les ilots isolants et/ou ladite zone métallique. Une telle barrière de diffusion empêche la diffusion de métal dans le matériau diélectrique.

L'invention concerne également un procédé de mesure de résistance et/ou de résistance carré à l'aide d'une structure telle que définie précédemment.

L'invention concerne également un procédé d'estimation d'épaisseur d'au moins une ligne métallique d'interconnexion dans lequel on effectue :

- au moins une première mesure de résistance carrée à une première température, à l'aide d'une structure telle que définie précédemment, intégré à un dispositif microélectronique comprenant ladite ligne d'interconnexion, d'un dispositif microélectronique comprenant ladite ligne métallique,
- au moins une deuxième mesure de résistance carrée à une deuxième température différente de ladite première température et à l'aide de ladite structure.

L'invention permet d'obtenir des mesures plus simplement et plus rapidement, compatibles avec les tests électriques couramment effectués en cours et en fin de fabrication des circuits en microélectronique.

**BRÈVE DESCRIPTION DES DESSINS**

La présente invention sera mieux comprise à la lecture de la description d'exemples de réalisation donnés, à titre purement indicatif et nullement limitatif, en faisant référence aux dessins annexés sur lesquels :

- les figures 1A-1B illustrent des phénomènes communément appelés de « dishing » et « d'érosion » lors d'une réalisation par procédé Damascène de lignes métalliques d'interconnexion,
- la figure 2, illustre un exemple de structure de test dans un dispositif microélectronique suivant l'invention,
- les figures 3A et 3B, illustrent une couche barrière de diffusion autour d'ilots métalliques et isolants dans une structure de test mise en oeuvre dans un dispositif microélectronique suivant l'invention.

## EXPOSÉ DÉTAILLÉ DE MODES DE RÉALISATION PARTICULIERS

Un exemple de dispositif microélectronique doté d'une structure de test selon l'invention, va à présent être décrit en liaison avec la figure 2.

Cette structure est formée sur un substrat sur lequel une pluralité de composants et de lignes d'interconnexions des composants sont également réalisés.

La structure de test comporte une zone métallique 110 connectée à des plots 102, 104, 106, 108 conducteurs, la zone métallique et les plots étant insérés dans une zone isolante 100.

La zone isolante 100 peut être une région d'une couche de matériau diélectrique 101 ou issue d'une couche de matériau diélectrique 101, par exemple tel que du $SiO_2$.

La zone isolante 100 peut avoir une surface par exemple comprise entre 1,5 fois et 2,5 fois la surface occupée par la zone métallique 110, par exemple de l'ordre de deux fois la surface occupée par la zone métallique.

Un premier plot 102 conducteur, est connecté à une première portion métallique 112 de la zone métallique 110 et est prévu pour recevoir un premier courant, servant de courant de test, par exemple dans la gamme 0,1 mA à 10 mA.

Un deuxième plot 104 conducteur, est connecté à une deuxième portion métallique 114 de la zone métallique 110 et est prévu pour l'évacuation dudit courant de test.

Un troisième plot 106 conducteur, est connecté à une troisième portion métallique 116 de la zone métallique 110 et est prévu pour servir de point haut de mesure d'une tension, tandis qu'un quatrième plot 108 conducteur, est connecté à une quatrième portion métallique 118 de la zone métallique et forme un point bas de mesure de ladite tension.

Les portions métalliques 112, 114, 116, 118, peuvent être sous forme de pistes ou de bandes métalliques.

La zone métallique 110 peut comporter également une partie centrale 110a qui peut être par exemple de forme rectangulaire ou carré, et à laquelle sont connectées les troisième et quatrième portions métalliques 116, 118 prévues pour la mesure de tension.

La zone métallique 110 peut être également dotée d'une deuxième partie et d'une troisième partie 110b, 110c, de part et d'autre de la partie centrale 110a, par exemple de formes rectangulaires ou carrées, et à laquelle sont connectées les troisième et quatrième portions métalliques 116, 118.

La partie centrale 110a de la zone métallique 110 peut avoir une largeur plus importante que celle des deuxièmes et troisièmes parties 110b, 110c. Cela peut être prévu de manière à intégrer des connexions propres à la mesure de tension.

La longueur Lo des parties 110b et 110c doit être au moins 5 fois supérieure à la longueur Lb de la partie 110a, afin de permettre une circulation de courant de manière homogène dans la partie 110a.

Des éléments métalliques que l'on appellera factices ou « dummies» sont également formés dans le matériau diélectrique 101 de la zone isolante 100. Ces éléments métalliques sont sous formes d'ilots métalliques 130, par exemple de forme carrée, et ont pour but, notamment, celui d'équilibrer les quantités de surfaces de matériau diélectrique 101 et de métal à l'intérieur de la zone isolante 100, afin de s'affranchir du phénomène d'érosion décrit précédemment du fait de trop grandes surfaces de matériau diélectrique.

Les ilots métalliques 130 sont répartis dans la zone isolante 100 autour de la zone métallique 110, et peuvent avoir par exemple la forme de plots rectangulaires ou carrés de dimension critique ou de largeur $w_1$ par exemple comprise entre 240 nm et 600 nm, par exemple de l'ordre de 480 nm. Certains ilots métalliques peuvent être situés entre les portions métalliques 112, 114, 116, 118. Les ilots métalliques 130 peuvent être espacés entre eux d'une distance $e_1$ par exemple comprise entre 100nm et 250nm, par exemple de l'ordre de 200nm.

Des éléments isolants que l'on appellera « factices » ou « dummies», sous forme d'ilots isolants 140 à base de matériau diélectrique 101, par exemple de forme rectangulaire ou carrée, se trouvent insérés dans la zone métallique 110. Ces ilots isolants 140 ont notamment pour but, celui d'équilibrer les quantités de surfaces de matériau diélectrique 101 et de métal de la zone métallique 110 à l'intérieur de la zone isolante 100, afin d'éviter les phénomènes de « dishing» évoqués précédemment et qui seraient dus à une trop grande surface de métal par rapport à la surface de matériau isolant.

Les ilots isolants 140 peuvent avoir par exemple une dimension critique ou une largeur $w_2$ par exemple comprise entre 240 nm et 600 nm, par exemple de l'ordre de 480 nm. Les ilots 140 de matériau diélectrique peuvent être espacés entre eux d'une distance $e_2$ par exemple comprise entre 100 nm et 250 nm, par exemple de l'ordre de 200 nm.

Le nombre et la taille des ilots métalliques peuvent être prévus au moins en fonction de la surface et de la géométrie occupée par la zone de matériau diélectrique, pour équilibrer les surfaces de matériau métallique et de matériau diélectrique, tandis que le nombre et la taille des ilots isolants peuvent être prévus au moins en fonction de la surface et de la géométrie occupée par la zone de matériau métallique, pour équilibrer les surfaces de matériau métallique et de matériau diélectrique.

Les ilots métalliques et isolant permettent donc d'équilibrer les surfaces de ces matériaux dans chacune des zones 100 et 110. Les dimensions S et W servent à régler la géométrie des ilots et des bandes entre deux matériaux pour aboutir à des surfaces identiques ou proches de matériau isolant et métallique.

Le nombre et la taille des ilots métalliques 130 et des ilots isolants 140 de matériau diélectrique peuvent être prévus de sorte que, à l'intérieur de la zone isolante 100, la surface de matériau diélectrique et de matériau métallique soient sensiblement égales ou diffèrent de moins de 10 %.

L'espace $e_2$ entre deux ilots isolants 140 est celui d'une ligne appartenant à la zone métallique 110 qui, de préférence, est suffisamment petite pour s'approcher de la largeur typique des lignes d'interconnexions de composants (non représentés sur cette figure) du dispositif microélectronique, par exemple d'une ou plusieurs dizaines de nanomètres, tout en ayant une largeur choisie supérieure aux imprécisions de fabrication d'une telle ligne, par exemple de l'ordre de plusieurs nanomètres.

L'espace $e_2$ est également prévu supérieur à l'épaisseur d'une couche barrière 150 de diffusion (figure 3A) qui peut être prévue notamment entre le matériau métallique de la zone 110 et le matériau diélectrique 101 des ilots isolants 140. Une telle couche barrière 150 peut être par exemple à base de TaN et peut être également prévue autour des ilots métalliques 130 (figure 3B), ainsi qu'autour de la zone métallique 110. La couche barrière 150 peut avoir une épaisseur par exemple de l'ordre de plusieurs nanomètres. Une telle couche barrière 150 est prévue pour empêcher le métal de la zone métallique 101 de diffuser dans la zone isolante 100 et dans les plots isolants 140. Une telle couche barrière 150 peut également permettre d'empêcher le métal des plots métalliques 130 dans la zone isolante 100.

Pour permettre une circulation du courant de manière homogène dans les deuxième et troisième parties 100b et 100c de la zone métallique 100 comprises respectivement entre une portion métallique 102 ou 104 de mesure de la tension et une portion métallique 106 ou 108 d'amenée de courant, ces parties 110b et 110c sont prévues avec une longueur $L_0$ (mesurée dans une direction parallèle au vecteur j d'un repère orthogonal [O; $\vec{i}$; $\vec{j}$; $\vec{k}$] de préférence suffisamment importante, par exemple de l'ordre de 75 fois $e_1$ par exemple de l'ordre de 15 μm dans un cas par exemple où $e_1$ = 200 nm .

La portion métallique 112, ainsi que la deuxième partie 110b de la zone métallique 110 peuvent avoir une longueur prévue de sorte que la zone d'amenée de courant correspondant à la longueur totale cumulée de la portion 112, et de la partie 110b de la zone métallique est supérieure, par exemple au moins 5 fois plus grande, que la longueur Lb (donnée sur la figure 2) de la partie servant à la mesure de tension et correspondant à la longueur de la partie 110a centrale de la zone métallique 110, ou de la distance entre les deux portions métalliques 116, 118 prévues pour la mesure de tension.

La partie centrale 100a située entre les portions métalliques 106, 108 servant de lignes de mesure de la tension, peut avoir une surface carrée ou sensiblement carrée, et une dimension qui peut être par exemple d'au moins 5*e2 + 6*w2.

La présente description donne des exemples de dimensions de la structure de test qui peuvent être adaptées ou modulées en fonction de la technologie de réalisation employée, et en particulier des dimensions critiques tolérées par cette technologie.

On peut réaliser le calcul de la résistance équivalente en terme de nombre de carrés, ceci peut être réalisé par un calcul ou à l'aide d'un outil de simulation par exemple avec un outil « ANSYS MULTIPHYSICS » de la société ANSYS, Inc. Software, on obtient alors:

$$R = \alpha * R\ carrée$$

avec R = résistance du motif mesurée par U/I, $\alpha$ = coefficient de forme du motif,
Rcarrée = résistance de couche du métal.

Un procédé de mesure tel que donné dans le document J.F. Guillaumond et al., Proc. of IITC 2003 conf., p. 132, est particulièrement bien adapté à la structure de test qui vient d'être décrite.

A partir de la mesure de la résistance carrée à deux températures différentes, par exemple 30˚c et 80˚C, d'obtenir ce paramètres :

$$\frac{(Rct2 - Rct1)}{(t2 - t1)} = \frac{\Delta \rho}{\Delta T} \times \frac{1}{e}$$

avec Rct2 une mesure de résistance carrée à une température t2,
Rct1 une mesure de résistance carrée à la température t1,

$\dfrac{\Delta \rho}{\Delta T}$ : le gradient de la résistivité en fonction de la température,

e : l'épaisseur de métal que l'on extrait de ce calcul.

Cela permet de mesurer la résistance carrée de manière précise et indépendante des effets du polissage mécano-chimique utilisé dans les technologies sub-microniques.

On peut également extraire l'épaisseur et la résistivité du métal qui sont des paramètres importants à mesurer et à suivre dans la fabrication des circuits en technologies microélectroniques.

La structure précédemment décrite permet d'obtenir ces paramètres à partir de mesures électriques automatisées simples et rapides, en même temps que les autres mesures électriques effectuées en cours et en fin de fabrication.

Cette structure de test et le procédé de mesure associé, sont adaptés à des tests lors d'une fabrication industrielle de dispositifs microélectroniques.

## Revendications

1. Dispositif microélectronique doté d'un ou plusieurs niveaux (M1,..., M5, M6) métalliques d'interconnexions superposés, et au moins une structure de test comportant :

    - au moins une zone métallique (110) formée dans au moins une zone isolante (100), la zone métallique comportant :

        • au moins une première portion métallique (112) par laquelle un courant est destiné à être injecté et au moins une deuxième portion métallique (114) par laquelle ledit courant est destiné à être extrait,
        • au moins une troisième portion métallique destinée à servir de premier point de mesure d'une tension, et au moins une quatrième portion métallique destinée à servir de deuxième point de mesure de ladite tension,
        • une pluralité d'ilots isolants (140) incorporés dans ladite zone métallique,

    ladite structure comportant en outre :

        - une pluralité d'ilots métalliques (130) incorporés dans la zone isolante et répartis autour de ladite zone métallique (110).

2. Dispositif microélectronique selon la revendication 1, le nombre et la taille des ilots métalliques (130) étant prévus au moins en fonction de la surface totale occupée par la zone isolante (100) entourant la zone métallique (110).

3. Dispositif microélectronique selon la revendication 1 ou 2, le nombre et la taille des ilots métalliques (130) et des ilots isolants (140) étant prévus de sorte que, à l'intérieur de la zone isolante (100), la surface de matériau diélectrique et de matériau métallique sont égales ou diffèrent de moins de 10 %.

4. Dispositif selon l'une des revendications 1 à 3, ladite zone isolante ayant une surface comprise entre 1,5 fois et 2,5 fois la surface de la zone métallique.

5. Dispositif selon l'une des revendications 1 à 4, les ilots métalliques (130) et/ou les ilots isolants (140) et/ou ladite zone métallique (110) étant entourés d'une couche barrière (150) de diffusion.

6. Procédé de mesure de résistance et/ou de résistance carrée à l'aide d'une structure selon l'une des revendications 1 à 5.

7. Procédé d'estimation de l'épaisseur d'au moins une ligne métallique d'interconnexion dans lequel on effectue :

    - au moins une première mesure de résistance carrée à une première température, à l'aide d'une structure selon l'une des revendications 1 à 5, intégré à un dispositif microélectronique comprenant ladite ligne d'interconnexion,
    - au moins une deuxième mesure de résistance carrée à une deuxième température différente de ladite première température et à l'aide de ladite structure.

FIG.1A

FIG.1B

FIG.2

FIG.3A

FIG.3B

# EP 2 071 624 A1

Europäisches Patentamt
European Patent Office
Office européen des brevets

## RAPPORT DE RECHERCHE EUROPEENNE

Numéro de la demande

EP 08 16 9227

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | EP 0 825 644 A (MOTOROLA INC [US]) 25 février 1998 (1998-02-25) * colonne 2, ligne 20 - colonne 6, ligne 42; figures 1-7 * ----- | 1-7 | INV. H01L23/544 |
| Y | US 6 635 501 B1 (ROWLAND DANIEL VINCENT [US]) 21 octobre 2003 (2003-10-21) * colonne 5, ligne 18 - colonne 5, ligne 56; figures 2-5 * ----- | 1-7 | |
| A | US 5 636 133 A (CHESEBRO DONALD G [US] ET AL) 3 juin 1997 (1997-06-03) * colonne 4, ligne 1 - colonne 7, ligne 2; figures 2-9b * ----- | 1-7 | |
| A | VAN DER PAUW L J: "A method of measuring the resistivity and hall coefficient on Lamellae of arbitrary shape" PHILIPS TECHNICAL REVIEW, PHILIPS, EINDHOVEN, NL, vol. 20, no. 8, 1 janvier 1958 (1958-01-01), pages 220-224, XP008093530 ISSN: 0031-7926 * page 230 - page 233 * ----- | 1-7 | DOMAINES TECHNIQUES RECHERCHES (IPC) H01L G01N |
| A | EP 0 813 239 A (TEXAS INSTRUMENTS INC [US]) 17 décembre 1997 (1997-12-17) * colonne 4, ligne 24 - colonne 8, ligne 5; figures 2a-5 * ----- | 1-7 | |
| A | WO 96/15552 A (INTEL CORP [US]) 23 mai 1996 (1996-05-23) * page 5, alinéa 1 - page 13, alinéa 1; figures 2a-3c * ----- | 1-7 | |

Le présent rapport a été établi pour toutes les revendications

| Lieu de la recherche | Date d'achèvement de la recherche | Examinateur |
|---|---|---|
| La Haye | 28 avril 2009 | Hedouin, Mathias |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 08 16 9227

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

28-04-2009

| Document brevet cité au rapport de recherche | | Date de publication | Membre(s) de la famille de brevet(s) | | Date de publication |
|---|---|---|---|---|---|
| EP 0825644 | A | 25-02-1998 | JP<br>SG<br>SG<br>US | 10092921 A<br>72750 A1<br>85687 A1<br>5885856 A | 10-04-1998<br>23-05-2000<br>15-01-2002<br>23-03-1999 |
| US 6635501 | B1 | 21-10-2003 | AUCUN | | |
| US 5636133 | A | 03-06-1997 | AUCUN | | |
| EP 0813239 | A | 17-12-1997 | JP | 9232417 A | 05-09-1997 |
| WO 9615552 | A | 23-05-1996 | AU<br>CN<br>EP<br>JP | 4235196 A<br>1171166 A<br>0791227 A1<br>10512098 T | 06-06-1996<br>21-01-1998<br>27-08-1997<br>17-11-1998 |

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0825644 A

**Littérature non-brevet citée dans la description**

- A method for measuring the resistivity and Hall Coefficient on lamellae of arbitrary shape. *Philips technical review,* 1954, vol. 20, 220-224